# EUROPEAN PATENT SPECIFICATION

(11) **EP 2 138 532 B1**
(45) Date of publication and mention of the grant of the patent: **18.05.2011**
(21) Application number: 09008317.1
(22) Date of filing: 25.06.2009
(51) Int. Cl.: C08J 7/04, B05D 7/24, C08F 30/02, C08F 230/02, C09D 143/02

(54) **Barrier laminate, gas barrier film and device**
Laminat mit Barrierewirkung, Gassperrfolie und Vorrichtung
Stratifié barrière, film à barrière contre les gaz et dispositif

(30) Priority: 25.06.2008 JP 2008165658
(43) Date of publication of application: 30.12.2009
(73) Proprietor: FUJIFILM Corporation, Tokyo 106-0031 (JP)
(72) Inventor: Oouchi, Ryou, Kanagawa 258-8577 (JP); Ito, Shigehide, Kanagawa 258-8577 (JP)
(74) Representative: HOFFMANN EITLE

(56) References cited:
- EP-A- 0 882 747
- EP-A- 1 142 704
- EP-A- 1 344 786
- US-A- 4 371 565

## Description

### Field of the invention

The present invention relates to a barrier laminate, a gas barrier film and a device.

### Description of the related art

In recent years, a film having a barrier property (hereinafter, referred to as a "gas barrier film") has been studied. For example, JP-A-2007-290369 discloses a gas barrier film in which a phosphoester is used as a material of an organic layer. JP-A-2007-30387 discloses a gas barrier film in which a compound having a phosphonate group is used as a material of an organic layer.

In a gas barrier film to be used for sealing up an image display device, or to be used for a substrate of an image display device, high barrier property tends to be required.

### Summary of the invention

JP-A-2007-290369 merely discloses that a phosphoester in which a phosphorus atom bonds to only oxygen atoms is used as a material of an organic layer. In such an organic layer, a P-O bond of the phosphoester readily hydrolyzes, and as the result, the gas barrier film may color by leaving it for a long period, or its inorganic layer may deteriorate over time due to a hydroxy group.

JP-A-2007-30387 discloses a compound having a phosphonate group as a material of the organic layer, but doesn't disclose any specific example using such a compound. That is, it is impossible to recognize the effect of using a compound having a phosphonate group from JP-A-2007-30387. Further, the inorganic layer of JP-A-2007-30387 deteriorates over time due to a hydroxy group, as the inorganic layer of JP-A-2007-290369 deteriorates.

In addition, when a (meth) acrylate having a phosphoester group, which is known to give high plasma resistance, high adhesiveness and high flexibility, is used as a material of an organic layer, the barrier laminate has poor weather-resistance such as coloration due to hydrolysis of the phosphoester group.

The object of the present invention is to solve the above problem, and is to provide a barrier laminate having higher barrier property, particularly to provide a barrier laminate which can be prevented from yellowing over time.

Given the situation as above, the present inventors have assiduously studied and have found that a barrier laminate which is prevented from hydrolyzing and has a high barrier property can be formed by using a monomer having a specific P-C bond in its organic layer. Concretely, the inventors have found that the above problems can be solved by the following measures.
[1] A barrier laminate comprising at least one organic layer and at least one inorganic layer, wherein the organic layer is formed by curing a polymerizable composition comprising a compound represented by the following formula (1): 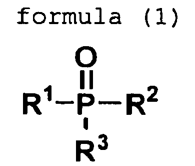 wherein R¹ represents an acryloyl group, a methacryloyl group, a vinyl group, an alkyl group having a substituent, or an aryl group having a substituent, when R¹ is an alkyl group having a substituent, or an aryl group having a substituent, each substituent contains an ethylenic double bond; R² and R³ each represent a vinyl group, an alkyl group having a substituent, an aryl group having a substituent, an alkoxy group having a substituent, or an aryloxy group having an substituent; R¹, R² and R³ may bond with each other to form a ring.
[2] The barrier laminate according to [1], wherein the substituent containing an ethylenic double bond contains an acryloyl group, a methacryloyl group, or a vinyl group.
[3] The barrier laminate according to [1], wherein R² and R³ each are an alkyl group, an aryl group, or an alkoxy group.
[4] The barrier laminate according to [1], wherein R¹ is an acryloyl group, a methacryloyl group, a vinyl group, an alkyl group having a substituent, or an aryl group having a substituent, the substituent containing an ethylenic double bond is an acryloyl group, a methacryloyl group, or a vinyl group, and R² and R³ each are an alkyl group, an aryl group, or an alkoxy group.
[5] The barrier laminate according to any one of [1] to [4], wherein the compound represented by the formula (1) is an acrylate compound or a methacrylate compound.
[6] The barrier laminate according to any one of [1] to [5], wherein the compound represented by the formula (1) has at least two polymerizable groups.
[7] The barrier laminate according to any one of [1] to [6], wherein the polymerizable composition comprises 1 to 50% by weight of the compound represented by the formula (1).
[8] The barrier laminate according to any one of [1] to [7], wherein the inorganic layer is on the organic layer.
[9] The barrier laminate according to any one of [1] to [8], wherein the organic layer is formed by a flash vapor deposition method.
[10] The barrier laminate according to any one of [1] to [9], wherein the inorganic layer comprises at least one species selected from a metal oxide, a metal nitride, a metal carbide, a metal oxide-nitride, and a metal oxide-carbide.
[11] The barrier laminate according to any one of [1] to [10], wherein the inorganic layer is formed by a sputtering method.
[12] The barrier laminate according to any one of [1] to [11], wherein at least two organic layers and at least two inorganic layers are laminated alternately.
[13] The barrier laminate according to any one of [1] to [12], wherein the polymerizable composition comprises polymerizable compound other than the compound represented by the formula (1) .
[14] A gas barrier film comprising a substrate and a barrier laminate according to any one of [1] to [13] on the substrate.
[15] A device comprising a barrier laminate according to any one of [1] to [13].
[16] The device according to [15], which has a gas barrier film as a substrate and the gas barrier film has the barrier laminate on a substrate film.
[17] The device according to [15] or [16], sealed up with a gas barrier film having the barrier laminate on a substrate film.
[18] The device according to [15] or [16], sealed up with the barrier laminate.
[19] The device according to any one of [15] to [18], which is an electronic device.
[20] The device according to any one of [15] to [18], which is an organic EL device.

The present invention makes it possible to provide a barrier laminate without coloration and with excellent barrier property and adhesiveness.

### Description of Specific Embodiments

The contents of the present invention are described in detail hereinunder. In this description, the numerical range expressed by the wording "a number to another number" means the range that falls between the former number indicating the lowermost limit of the range and the latter number indicating the uppermost limit thereof. "Organic EL device" as referred to herein means an organic electroluminescent device. In addition, "(meth)acrylate" means acrylate and methacrylate in the present specification.

### (Barrier laminate)

The barrier laminate of the present invention comprises at least one organic layer and at least one inorganic layer, wherein the organic layer is formed by curing a polymerizable composition comprising a compound represented by the formula (1). By employing such an organic layer, the barrier laminate can be prevented from yellowing due to hydrolysis. In addition, by employing an organic layer in the present invention, adhesiveness between the organic layer and an inorganic layer adjacent to the organic layer is enhanced, thereby obtaining a barrier laminate excellent in barrier property. The barrier laminate of the present invention preferably has an alternate layer structure, in which at least two organic layers and at least two inorganic layers are laminated alternately.

### (Organic layer)

At least one organic layer in the barrier laminate of the present invention is formed by curing a polymerizable composition comprising a compound represented by the following formula (1): 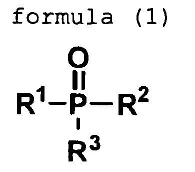 wherein R¹ represents an acryloyl group, a methacryloyl group, a vinyl group, an alkyl group having a substituent, or an aryl group having a substituent, when R¹ is an alkyl group having a substituent, or an aryl group having a substituent, each substituent contains an ethylenic double bond; R² and R³ each represent a vinyl group, an alkyl group having a substituent, an aryl group having a substituent, an alkoxy group having a substituent, or an aryloxy group having an substituent; R¹, R² and R³ may bond with each other to form a ring.

R¹ preferably has an ethylenic double bond. The ethylenic double bond that R¹ has is preferably a (meth)acryloyl group, or a vinyl group, more preferably a (meth) acryloyl group. That is, the compound represented by the formula (1) is preferably a (meth) acrylate compound.

The substituents of R² and R³ each are preferably an alkyl group, an aryl group, or an alkoxy group, more preferably an alkyl group, or an aryl group, still more preferably an alkyl group.

Examples of the compound represented by the formula (1) are shown below, to which, however, these are not limited in the present invention.

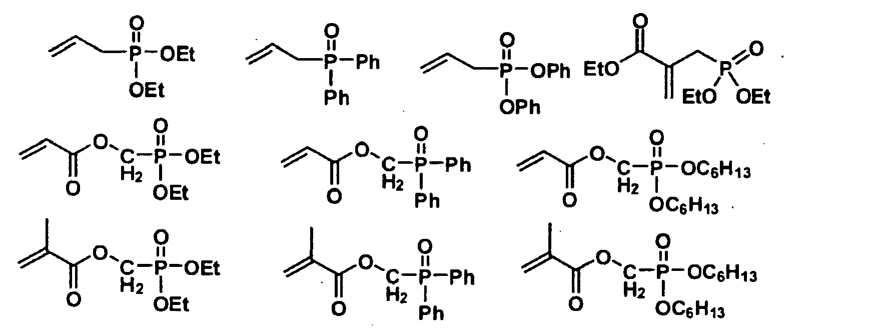

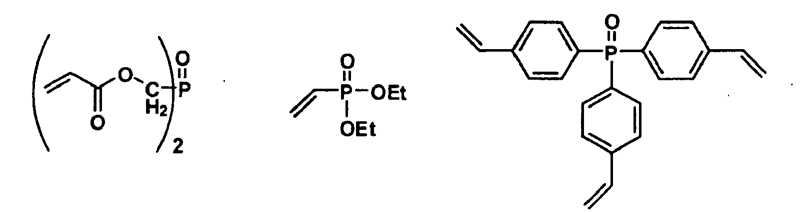

### (Other polymerizable compounds and other polymers)

The polymerizable composition in the present invention preferably contains a polymerizable compound other than the compound represented by the formula (1) in addition to the compound represented by the formula (1). In this case, the content of the compound represented by the formula (1) in the polymerizable composition is preferably 1 to 50% by weight, more preferably 5 to 30% by weight. Examples of the polymerizable compound other than the compound represented by the formula (1) include a (meth)acrylate compound, and preferably a polyfunctional (meth)acrylate compound.

The organic layer may contain other polymer than the above polymer. Examples of the polymer include polyester resins, methacrylic acid/maleic acid copolymers, polystyrene resins, transparent fluoro-resins, polyimide resins, fluorinated polyimide resins, polyamide resins, polyamidimide resins, polyetherimide resins, cellulose acylate resins, polyurethane resins, polyether ketone resins, polycarbonate resins, alicyclic polyolefin resins, polyarylate resins, polyether sulfone resins, polysulfone resins, fluorene ring-modified polycarbonate resins, alicyclic ring-modified polycarbonate resins and fluorene ring-modified polyesters.

### (Polymerization initiator)

The polymerizable composition in the present invention may include a polymerization initiator. In the case where a photopolymerization initiator is used, its amount is preferably at least 0.1 mol% of the total amount of the polymerizing compound, more preferably from 0.5 to 2 mol%. By setting the thus-designed composition, polymerization reaction though an active ingredient forming reaction may be suitably controlled. Examples of the photopolymerization initiator include Ciba Speciality Chemicals' commercial products, Irgacure series (e.g., Irgacure 651, Irgacure 754, Irgacure 184, Irgacure 2959, Irgacure 907, Irgacure 369, Irgacure 379, Irgacure 819), Darocure series (e.g., Darocure TPO, Darocure 1173), Quantacure PDO; Lamberti's commercial products, Ezacure series (e.g., Ezacure TZM, Ezacure TZT, Ezacure KT046), etc.

### (Method of formation of organic layer)

The method for forming the organic layer is not specifically defined. For example, the layer may be formed according to a solution coating method or a vacuum film formation method. The solution coating method is, for example, a dipping method, an air knife coating method, a curtain coating method, a roller coating method, a wire bar coating method, a gravure coating method, a slide coating method, or an extrusion coating method using a hopper as in USP 2681294. The vacuum film formation method is not specifically defined, but is preferably a film formation method by vapor deposition or plasma CVD. In the present invention, the polymer may be applied for coating as its solution, or a hybrid coating method along with an inorganic material, as in JP-A 2000-323273 and 2004-25732, may also be used. A vapor deposition method is advantageous in the formation of the organic layer in the present invention from the viewpoints of higher curing speed, densification of the layer, and reduction of a residual solvent amount.

In the present invention, the composition comprising the polymerizable monomer is cured by irradiation. The light for irradiation is generally a UV ray from a high-pressure mercury lamp or low-pressure mercury lamp. The radiation energy is preferably at least 0.1 J/cm², more preferably at least 0. 5 J/cm². (Meth)acrylate series compounds may suffer from interference in polymerization owing to oxygen in air, and therefore, in their polymerization, the oxygen concentration or the oxygen partial pressure is preferably lowered. In the case where the oxygen concentration in polymerization is lowered according to a nitrogen purging method, the oxygen concentration is preferably not more than 2 %, more preferably not more than 0.5 %. In the case where the oxygen partial pressure in polymerization is lowered by a pressure reduction method, the whole pressure is preferably not more than 1000 Pa, more preferably not more than 100 Pa. Especially preferred is UV polymerization with at least 0.5 J/cm² energy radiation under a condition of reduced pressure of not more than 100 Pa.

The organic layer is preferably smooth and has high membrane strength. The mean roughness (Ra) of 1 µm² of the organic layer is preferably not more than 1 nm, more preferably not more than 0.5 nm. Preferably, the rate of polymerization of monomer is at least 85 %, more preferably at least 88 %, even more preferably at least 90 %, still more preferably at least 92 %. The rate of polymerization as referred to herein means the ratio of the reacted polymerizable group to all the polymerizing group (acryloyl group and methacryloyl group) in the monomer mixture. The rate of polymerization may be quantitatively determined according to IR absorptiometry.

The thickness of the organic layer is not specifically defined. However, when the layer is too thin, then its thickness could hardly keep uniformity; but when too thick, the layer may be cracked by external force applied thereto and its barrier property may lower. From these viewpoints, the thickness of the organic layer is preferably from 50 nm to 2000 nm, more preferably from 200 nm to 1500 nm.

As so mentioned in the above, the organic layer is preferably smooth. The mean roughness (Ra) is preferably not more than 1 nm, more preferably not more than 0. 5 nm. The surface of the organic layer is required not to have impurities and projections such as particles. Accordingly, it is desirable that the organic layer is formed in a clean room. The degree of cleanness is preferably not more than class 10000, more preferably not more than class 1000.

Preferably, the hardness of the organic layer is higher. It is known that, when the hardness of the organic layer is high, then the inorganic layer may be formed smoothly and, as a result, the barrier level of the gas barrier film is thereby improved. The hardness of the organic layer may be expressed as a microhardness based on a nano-indentation method. The microhardness of the organic layer is preferably at least 100 N/mm, more preferably at least 150 N/mm.

Two or more organic layers are preferably laminated. In this case, each layer may have the same composition or may have different compositions. In the case where two or more organic layers are laminated, they are preferably so designed that each organic layer could fall within the above-mentioned preferred range. As so mentioned in the above, the organic layer may be included as a layer have a composition continuously changing in the direction of the layer thickness with no definite interface between an organic layer and an inorganic layer, as illustrated in USP-A 2004-46497.

### (Inorganic Layer)

The inorganic layer is, in general, a layer of a thin film formed of a metal compound. For forming the inorganic layer, employable is any method capable of producing the intended thin film. For it, for example, suitable are physical vapor deposition methods (PVD) such as vapor evaporation method, sputtering method, ion plating method; various chemical vapor deposition methods (CVD); liquid phase growth methods such as plating or sol-gel method. In the present invention, the high barrier property is attained even if the inorganic layer formed by a sputtering method. Not specifically defined, the component to be in the inorganic layer may be any one satisfies the above-mentioned requirements. For example, it includes metal oxides, metal nitrides, metal carbides, metal oxide-nitrides, or metal oxide-carbides. Preferably used are oxides, nitrides, carbides, oxide-nitrides, or oxide-carbides comprising at least one metal selected from Si, Al, In, Sn, Zn, Ti, Cu, Ce and Ta. Of those, preferred are oxides, nitrides, or oxide-nitrides of a metal selected from Si, Al, In, Sn, Zn and Ti; more preferred are oxides, nitrides or oxide-nitrides with Si or Al. These may contain any other element as a subsidiary component. The present invention is advantageous because the barrier laminate having high barrier property is obtained even if its inorganic layer is produced by using a metal oxide as a material thereof through plasma process.

Preferably, the surface smoothness of the inorganic layer formed in the present invention is less than 1 nm in terms of the mean roughness (Ra value) in 1 µm square, more preferably not more than 0.3 nm. Accordingly, it is desirable that the inorganic layer is formed in a clean room. Preferably, the degree of cleanness is not more than class 10000, more preferably not more than class 1000.

Not specifically defined, the thickness of the inorganic layer is generally within a range of from 5 to 500 nm/layer, preferably from 10 to 200 nm/layer. The inorganic layer may be a laminate composed of a plurality of sub-layers. In this case, each sub-layer may have the same composition, or a different composition. In addition, as so mentioned hereinabove and as disclosed in UP Laid-Open 2004-46497, the inorganic layers may be gradation layers of which the composition changes continuously in the thickness direction of the layer, with no definite boundary to the adjacent inorganic layer.

### (Lamination of Organic Layer and Inorganic Layer)

The organic layer and the inorganic layer may be laminated by repeated film formation to form the organic layer and the inorganic layer in a desired layer constitution. In case where the inorganic layer is formed according to a vacuum film formation method such as sputtering method, vacuum evaporation method, ion plating method or plasma CVD method, then it is desirable that the organic layer is also formed according to a vacuum film formation method such as the above-mentioned flash vapor deposition method. While the barrier layer is formed, it is especially desirable that the organic layer and the inorganic layer are laminated all the time in a vacuum of not more than 1000 Pa, not restoring the pressure to an atmospheric pressure during the film formation. More preferably, the pressure is not more than 100 Pa, even more preferably not more than 50 Pa, still more preferably not more than 20 Pa.

Particularly, in the case where at least two organic layers and at least two inorganic layers are laminated alternately, the present invention can achieve higher barrier property.

### (Functional Layer)

The device of the present invention may have a functional layer on the barrier laminate or in any other position. The functional layer is described in detail in JP-A 2006-289627, paragraph 0036 to 0038. Examples of other functional layers than those are a matting agent layer, a protective layer, an antistatic layer, a planarizing layer, an adhesiveness improving layer, a light shielding layer, an antireflection layer, a hard coat layer, a stress relaxing layer, an antifogging layer, an anti-soiling layer, a printable layer, an adhesive layer, etc.

### (Use of Barrier Laminate)

In general, the barrier laminate of the present invention is formed on a support. Selecting the support, the barrier laminate may have various applications. The support includes a substrate film, as well as various devices, optical members, etc. Concretely, the barrier laminate of the present invention may be used as a barrier layer of a gas barrier film. The barrier laminate and the gas barrier film of the present invention may be used for sealing up devices that require gas-barrier property. The barrier laminate and the gas barrier film of the present invention may apply optical members. These are described in detail hereinunder.

### (Gas barrier film)

The gas barrier film comprises a substrate film and a barrier laminate formed on the substrate film. In the gas barrier film, the barrier laminate of the present invention may be provided only one surface of the substrate film, or may be provided on both surfaces thereof. The barrier laminate of the present invention may be laminated in an order of an inorganic layer and an organic layer from the side of the substrate film; or may be laminated in an order of an organic layer and an inorganic layer from it. The uppermost layer of the laminate of the present invention may be an inorganic layer or an organic layer.

The gas barrier film of the present invention is a film substrate having a barrier layer that functions to block oxygen, water, nitrogen oxide, sulfur oxide, ozone and others in air.

Not specifically defined, the number of the layers that constitute the gas barrier film may be typically from 2 layers to 30 layers, more preferably from 3 layers to 20 layers.

The gas barrier film may have any other constitutive components (e.g., functional layers such as adhesive layer) in addition to the barrier laminate and the substrate film. The functional layer may be disposed on the barrier laminate, or between the barrier laminate and the substrate film, or on the side (back) of the substrate film not coated with the barrier laminate.

### (Plastic Film)

In the gas barrier film of the present invention, the substrate film is generally a plastic film. Not specifically defined in point of the material and the thickness thereof, the plastic film usable herein may be any one capable of supporting a laminate of an organic layer and an inorganic layer; and it may be suitably selected depending on the use and the object thereof. Concretely, the plastic film includes thermoplastic resins such as polyester resin, methacryl resin, methacrylic acid-maleic anhydride copolymer, polystyrene resin, transparent fluororesin, polyimide, fluoropolyimide resin, polyamide resin, polyamidimide resin, polyetherimide resin, cellulose acylate resin, polyurethane resin, polyether ether ketone resin, polycarbonate resin, alicyclic polyolefin resin, polyarylate resin, polyether sulfone resin, polysulfone resin, cycloolefin copolymer, fluorene ring-modified polycarbonate resin, alicyclic-modified polycarbonate resin, fluorene ring-modified polyester resin, acryloyl compound.

In case where the gas barrier film of the present invention is used as a substrate of a device such as an organic EL device to be mentioned hereinunder, it is desirable that the plastic film is formed of a heat-resistant material. Concretely, the plastic film is preferably formed of a heat-resistant transparent material having a glass transition temperature (Tg) of not lower than 100°C and/or a linear thermal expansion coefficient of not less than 40 ppm/°C. Tg and the linear expansion coefficient may be controlled by the additives to the material. The thermoplastic resin of the type includes, for example, polyethylene naphthalate (PEN: 120°C), polycarbonate (PC: 140°C), alicyclic polyolefin (e.g., Nippon Zeon's Zeonoa 1600: 160°C), polyarylate (PAr: 210°C), polyether sulfone (PES: 220°C), polysulfone (PSF: 190°C), cycloolefin copolymer (COC, compound described in JP-A 2001-150584: 162°C), polyimide (Mitsubishi gas chemical company's Neopulim : 260 °C), fluorene ring-modified polycarbonate (BCF-PC, compound described in JP-A 2000-227603: 225°C), alicyclic-modified polycarbonate (IP-PC, compound described in JP-A 2000-227603: 205°C), acryloyl compound (compound described in JP-A 2002-80616: 300°C or more) (the parenthesized data are Tg). In particular, for high transparency, use of alicyclic polyolefin is preferred.

In the case where the gas barrier film of the present invention is used in combination with a polarizing plate, it is preferable that the gas barrier layer surface of the gas barrier film is faced at the inside of a cell and is disposed in the innermost (adjacent to the device) . At that time, since the gas barrier film is disposed in the inside of the cell relative to the polarizing plate, a retardation value of the gas barrier film is important. As to a use form of the gas barrier film in such an embodiment, it is preferable that a barrier film using a base material film having a retardation value of not more than 10 nm and a circular polarizing plate ((quarter-wave plate) + (half-wave plate) + (linear polarizing plate)) are laminated and used, or that a linear polarizing plate is combined with a gas barrier film using a base material film having a retardation value of from 100 nm to 180 nm, which can be used as a quarter-wave plate, and used.

Examples of the base material film having a retardation of not more than 10 nm include cellulose triacetate (FUJITAC, manufactured by Fujifilm Corporation), polycarbonates (PURE-ACE, manufactured by Teijin Chemicals Ltd.; and ELMECH, manufactured by Kaneka Corporation), cycloolefin polymers (ARTON, manufactured by JSR Corporation; and ZEONOR, manufactured by Zeon Corporation), cycloolefin copolymers (APEL (pellet), manufactured by Mitsui Chemicals, Inc.; and TOPAS (pellet), manufactured by Polyplastics Co., Ltd.), polyarylates (U100 (pellet), manufactured by Unitika Ltd.) and transparent polyimides (NEOPULIM, manufactured by Mitsubishi Gas Chemical Company).

Also, films obtained by properly stretching the foregoing film to adjust it so as to have a desired retardation value can be used as the quarter-wave plate.

In view of the matter that the gas barrier film of the present invention is utilized as a device such as organic EL devices, the plastic film must be transparent, namely its light transmittance is usually not less than 80%, preferably not less than 85%, and more preferably not less than 90%. The light transmittance can be measured by a method described in JIS-K7105, namely by measuring a total light transmittance and an amount of scattered light using an integrating sphere type light transmittance analyzer and subtracting the diffuse transmittance from the total light transmittance.

Even in the case where the gas barrier film of the present invention is used for display use, for example, when it is not disposed on the side of an observer, the transparency is not always required. Accordingly, in such case, an opaque material can also be used as the plastic film. Examples of the opaque material include a known liquid crystal polymer such as polyimides and polyacrylonitrile.

The thickness of the plastic film to be used for the gas barrier film of the present invention is properly chosen depending upon the use and therefore, is not particularly limited. It is typically from 1 to 800 µm, preferably from 10 to 200 µm. These plastic films may have a functional layer such as a transparent conductive layer and a primer layer. The functional layer is described in detail in paragraphs 0036 to 0038 of JP-A-2006-289627. Examples of functional layers other than these layers include a matting agent layer, a passivation layer, an antistatic layer, a smoothening layer, an adhesion improving layer, a light shielding layer, an antireflection layer, a hard coat layer, a stress relaxing layer, an antifogging layer, an antifouling layer, a layer to be printed and an easily adhesive layer.

### (Device)

The barrier laminate and the gas barrier film of the present invention are favorably used for devices that are deteriorated by the chemical components in air (e.g., oxygen, water, nitrogen oxide, sulfur oxide, ozone). Examples of the devices are, for example, organic EL devices, liquid-crystal display devices, thin-film transistors, touch panels, electronic papers, solar cells, other electronic devices. More preferred are organic EL devices.

The barrier laminate of the present invention may be used for film-sealing of devices. Specifically, this is a method of providing a barrier laminate of the present invention on the surface of a device serving as a support by itself. Before providing the barrier laminate, the device may be covered with a protective layer.

The gas barrier film of the present invention may be used as a substrate of a device or as a film for sealing up according to a solid sealing method. The solid sealing method comprises forming a protective layer on a device, then forming an adhesive layer and a gas barrier film as laminated thereon, and curing it. Not specifically defined, the adhesive may be a thermosetting epoxy resin, a photocurable acrylate resin, etc.

### (Organic EL Device)

Examples of an organic EL device with a gas barrier film are described in detail in JP-A 2007-30387.

### (Liquid-Crystal Display Device)

A reflection-type liquid-crystal display device has a constitution of a lower substrate, a reflection electrode, a lower alignment film, a liquid-crystal layer, an upper alignment film, a transparent electrode, an upper substrate, a λ/4 plate and a polarizing film, formed in that order from the bottom. In this, the gas barrier film of the present invention may be used as the transparent electrode substrate and the upper substrate. In color displays, it is desirable that a color filter layer is additionally provided between the reflection electrode and the lower alignment film, or between the upper alignment film and the transparent electrode. A transmission-type liquid-crystal display device has a constitution of a backlight, a polarizer, a λ/4 plate, a lower transparent electrode, a lower alignment film, a liquid-crystal layer, an upper alignment film, an upper transparent electrode, an upper substrate, a λ/4 plate and a polarizing film, formed in that order from the bottom. In this, the substrate of the present invention may be sued as the upper transparent electrode and the upper substrate. In color displays, it is desirable that a color filter layer is additionally provided between the lower transparent electrode and the lower alignment film, or between the upper alignment film and the transparent electrode. Not specifically defined, the type of the liquid-crystal cell is preferably a TN (twisted nematic) type, an STN (super-twisted nematic) type, a HAN (hybrid aligned nematic) type, a VA (vertically alignment) type, an ECB (electrically controlled birefringence) type, an OCB (optically compensatory bent) type, a CPA (continuous pinwheel alignment) type, or an IPS (in-plane switching) type.

### (Solar Cell)

The gas barrier film of the invention can be used also as a sealing film for solar cell devices. Preferably, the gas barrier film of the invention is used for sealing a solar cell device in such a manner that its adhesive layer is on the side near to the solar cell device. The solar cell devices for which the gas barrier film of the invention is favorably used are not specifically defined. For example, they include single crystal silicon-based solar cell devices, polycrystalline silicon-based solar cell devices, single-junction or tandem-structure amorphous silicon-based solar cell devices, gallium-arsenic (GaAs), indium-phosphorus (InP) or the like III-V Group compound semiconductor-based solar cell devices, cadmium-tellurium (CdTe) or the like II-VI Group compound semiconductor-based solar cell devices, copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices, dye-sensitized solar cell devices, organic solar cell devices, etc. Above all, in the invention, the solar cell devices are preferably copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices.

### (Others)

Other applications of the present invention are thin-film transistors as in JP-T 10-512104, touch panels as in JP-A 5-127822, 2002-48913, and electronic papers as in JP-A 2000-98326.

### (Optical Member)

An example of the optical member that comprises the barrier laminate of the present invention is a circular polarizer.

### (Circular Polarizer)

Laminating a gas barrier film of the invention with a λ/4 plate and a polarizer gives a circular polarizer. In this case, the components are so laminated that the slow axis of the λ/4 plate could cross the absorption axis of the polarizer at an angle of 45°. The polarizer is preferably stretched in the direction of 45° from the machine direction (MD) thereof; and for example, those described in JP-A 2002-865554 are favorably used.

### EXAMPLES

The characteristics of the present invention are described more concretely with reference to the following Examples. The present invention should not be limitatively interpreted by the Examples mentioned below.

### Formation of a gas barrier film (1)

A main monomer shown in the following table and a compound represented by the formula (1) shown in the following table were mixed at a weight ratio of 5:1, and a polymerization initiator (Chiba Speciality Chemicals, IRGACURE907) was added to prepare a polymerizable composition.

The above polymerizable composition was prepared by using methyl ethyl ketone, so that a film having a dry film thickness of 500 nm is formed on a substrate (manufactured by DuPont, Teonex Q65FA, having a thickness of 100 µm), and then cured through irradiation with UV rays at a dose of 0.5 J/cm² in atmosphere having 100 ppm of oxygen, thereby producing the organic layer. Aluminum oxide was deposited on the surface of the formed organic layer according to a vacuum sputtering method (reactive sputtering) to form a layer having thickness of 30 nm, thereby producing a gas barrier film. The obtained gas barrier films were tested and evaluated for water vapor permeability and adhesiveness according to the methods below.

### [Evaluation of barrier property - MOCON method]

Water vapor permeability of each gas barrier film after just formed and after 1000 hours from the formation was measured at 40 °C 90% RH by using "PERMATRAN-W3/31" manufactured by MOCON. The detection limit is 0.005 g/m² day. The measured water vapor permeability was evaluated by the following gauge and the results are shown below.
⊚: not more than 0.005
○:more than 0.005 to not more than 0.01
Δ:more than 0.01 to not more than 0.1
×: more than 0.1

### [Evaluation of yellowing over time]

Transparent spectrum (wavelength : 400 nm) for each gas barrier films after just formed and after 1000 hours from the formation was measured at 40 °C 90% RH. The measured yellowing was evaluated by the following gauge and the results are shown below.
⊚: not less than 70%
○:not less than 50% to less than 70%
×: less than 50%

### [Measurement for adhesiveness]

In order to evaluate adhesiveness of each gas barrier films, cross-cut adhesiveness test compliant to JIS K5400 was carried out. The surface of the gas barrier films having the above construction was cut in at the entering angle of 90 degree toward the film surface at 1 mm interval, thereby producing one hundred of cross-cut at 1 mm interval. On the surface thereof, Mylar tape having the wide of 2 cm (manufactured by Nitto Denko, polyester tape, No. 31B) was attached, and then was peeled off using a tape peeling testing machine. The number (n) of the remaining grids which didn't peel off from one hundred of cross-cut on the laminated film was counted. The results are shown by %.
⊚: 91 to 100
○: 51 to 90
Δ: 11 to 50
×:0 to 10

**[Table 1]**

| | Main monomer | Compound of the formula (1) or an alternative | Barrier property (after just formed) | Barrier property (over time) | Yellow over time | Adhesiveness |
|---|---|---|---|---|---|---|
| Example 1 | BEPGA | DEMMP | ⊚ | ⊚ | ⊚ | ⊚ |
| Example 2 | BEPGA | ADPPO | ⊚ | ⊚ | ⊚ | ⊚ |
| Example 3 | TMPTA | DEMMP | ⊚ | ⊚ | ⊚ | ⊚ |
| Comparative Example 1 | BEPGA | P-2M | ⊚ | × | × | ⊚ |
| Comparative Example 2 | BEPGA | - | ○ | ○ | ○ | × |
| Comparative Example 3 | BEPGA | Vinyl sulfonic acid | ○ | × | Δ | ⊚ |

The compounds in the above table 1 are shown below :

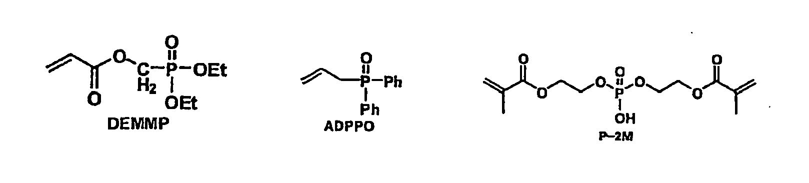

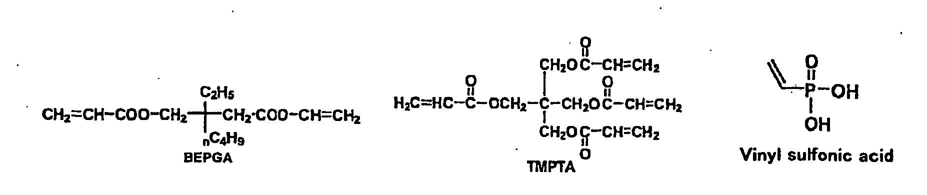

Furthermore, precise barrier property in Example 1, Example 2 and Comparative Example 2 was measured by the following method.

### [Evaluation of barrier property - Ca method]

The water vapor permeability (g/m²/day) was measured according to the method described in G. NISATO, P.C.P. BOUTEN, P.J. SLIKKERVEER, et al.; SID Conference Record of the International Display Research Conference 1435-1438. The measure was carried out at 40°C and 90% RH. The results are shown in the following table.

**[Table 2]**

| | Barrier property (after just formed) (g/m²/day) | Barrier property (over time) (g/m²/day) |
|---|---|---|
| Example 1 | 1.5×10⁻³ | 3.3×10⁻³ |
| Example 2 | 3.1×10⁻³ | 4.5×10⁻³ |
| Comparative Example 2 | 5.8×10⁻³ | 6.5×10⁻³ |

As is clear from the above results, it was found that the gas barrier film using a compound represented by the formula (1) as a material of its organic layer was excellent in barrier property in extremely high level.

### [Evaluation in Organic EL Device]

In order to evaluate gas barrier property, an organic EL device in which vapor or oxygen causes dark spot was formed. An ITO film-having conductive glass substrate (surface resistivity, 10 Ω/square) was washed with 2-propanol, and then processed for UV ozone treatment for 10 minutes. On the substrate (anode), the following compound layers were formed in order by vapor deposition according to a vacuum vapor deposition method.

### (First Hole Transporting Layer)

Copper phthalocyanine: film thickness 10 nm.

### (Second Hole Transporting Layer)

N,N'-diphenyl-N,N'-dinaphthylbenzidine: film thickness 40 nm. (Light-Emitting Layer also serving as electron transporting layer)

Tris(8-hydroxyquinolinato)aluminium: film thickness 60 nm.

### (Electron Injection Layer)

Lithium fluoride: film thickness 1 nm.

Aluminium was formed on it through vapor deposition to form a cathode having a thickness of 100 nm, and a silicon nitride film having a thickness of 3 µm was formed thereon according to a parallel plate CVD method, thereby constructing an organic EL device.

Next, using a thermosetting adhesive (Epotec 310, by Daizo-Nichimori), the gas barrier films formed above and the organic EL device were stuck together in such a manner that the side of the barrier layer could be on the side of the organic EL device, and heated at 65°C for 3 hours to cure the adhesive. 20 test pieces of every sample of the thus-sealed organic EL device were prepared.

Just after produced, the organic EL device was tested for light emission under application of 7 V thereto, using a source measure unit (SMU2400 Model by Keithley). Using a microscope, the light-emitting surface was observed, which confirmed uniform light emission by every device with no dark spot.

Finally, the devices were stored in a dark room at 60°C and 90% RH for 24 hours, and then tested for light emission. The proportion of the test pieces that gave dark spots larger than 300 µm in diameter is defined as a failure rate. The failure rate of every sample was computed. The devices of the present invention were the failure rate of 5% or below, and were good.

### Formation of a gas barrier film (2)

Gas barrier films of Examples 4 to 6 were formed in the same manner as Examples 1 to 3, respectively, except that the polymerization initiator (Chiba Speciality Chemicals, IRGACURE907) was changed to a polymerization initiator (Lambertis, Ezacure KT046). The waver vapor permeability, yellowing over time and adhesiveness for the obtained gas barrier films were evaluated according to the same manner as those in Example 1. The results are shown in Table 3. It was found that the gas barrier films of Examples 4 to 6 are excellent in barrier property and yellow over time. Organic EL devices having the above gas barrier films of Examples 4 to 6 were formed according to the same manner. The organic EL devices successfully lighted up.

**[Table 3]**

| | Based monomer | Compound of the formula (1) or an alternative | Barrier property (after just formed) | Barrier property (over time) | Yellow over time | Adhesiveness |
|---|---|---|---|---|---|---|
| Example 4 | BEPGA | DEMMP | ⊚ | ⊚ | ⊚ | ⊚ |
| Example 5 | BEPGA | ADPPO | ⊚ | ⊚ | ⊚ | ⊚ |
| Example 6 | TMPTA | DEMMP | ⊚ | ⊚ | ⊚ | ⊚ |

### Industrial applicability

The gas barrier film of the present invention has high barrier property, then it is possible to use widely for various types of devices in which barrier property is required.

Since the barrier laminate of the present invention makes it possible to enhance adhesiveness between an organic layer and a layer adjacent to the organic layer, it is possible to enhance the barrier property greatly. Since the barrier laminate of the present invention employs a compound having a phosphoester group, which gives strong flexibility, it is possible to enhance flexibility of the gas barrier film. On the other hand, the present invention can prevent the barrier film from yellowing due to hydrolysis which is likely to be caused by a phosphate compound. Thereby, the present invention can provide the barrier laminate excellent in weather resistance. Particularly, the present invention is advantage because it is possible to provide the barrier laminate satisfying all of those.

## Claims

1. A barrier laminate comprising at least one organic layer and at least one inorganic layer, wherein the organic layer is formed by curing a polymerizable composition comprising a compound represented by the following formula (1): 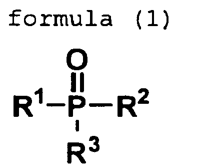 wherein R¹ represents an acryloyl group, a methacryloyl group, a vinyl group, an alkyl group having a substituent, or an aryl group having a substituent, when R¹ is an alkyl group having a substituent, or an aryl group having a substituent, each substituent contains an ethylenic double bond; R² and R³ each represent a vinyl group, an alkyl group having a substituent, an aryl group having a substituent, an alkoxy group having a substituent, or an aryloxy group having an substituent; R¹, R² and R³ may bond with each other to form a ring.

2. The barrier laminate according to Claim 1, wherein the substituent containing an ethylenic double bond contains an acryloyl group, a methacryloyl group, or a vinyl group.

3. The barrier laminate according to Claim 1 or 2, wherein R² and R³ each are an alkyl group, an aryl group, or an alkoxy group.

4. The barrier laminate according to any one of Claims 1 to 3, wherein the compound represented by the formula (1) is an acrylate compound or a methacrylate compound.

5. The barrier laminate according to any one of Claims 1 to 4, wherein the compound represented by the formula (1) has at least two polymerizable groups.

6. The barrier laminate according to any one of Claims 1 to 5, wherein the polymerizable composition comprises 1 to 50% by weight of the compound represented by the formula (1).

7. The barrier laminate according to any one of Claims 1 to 6, wherein the inorganic layer is on the organic layer.

8. The barrier laminate according to any one of Claims 1 to 7, wherein the organic layer is formed by a flash vapor deposition method.

9. The barrier laminate according to any one of Claims 1 to 8, wherein the inorganic layer comprises at least one species selected from a metal oxide, a metal nitride, a metal carbide, a metal oxide-nitride, and a metal oxide-carbide.

10. The barrier laminate according to any one ot Claims 1 to 9, wherein the inorganic layer is formed by a sputtering method.

11. The barrier laminate according to any one of Claims 1 to 10, wherein at least two of organic layers and at least two of inorganic layers are laminated alternately.

12. A gas barrier film comprising a substrate and the barrier laminate according to any one of Claims 1 to 11 on the substrate.

13. A device comprising the barrier laminate according to any one of Claims 1 to 11.

14. The device according to Claim 13, which has the gas barrier film according to Claim 12 as a substrate.

15. The device according to Claim 13 or 14, sealed up with the barrier laminate, or the gas barrier film according to Claim 11.

16. The device according to any one of Claims 13 to 15, which is an electronic device or an organic EL device.

## Patentansprüche

1. Laminat mit Barrierewirkung, umfassend mindestens eine organische Schicht und mindestens eine anorganische Schicht, worin die organische Schicht gebildet ist durch Härten einer polymerisierbaren Zusammensetzung, die eine durch die folgende Formel (1) dargestellte Verbindung umfasst: 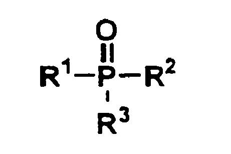 worin R¹ eine Acryloylgruppe, eine Methacryloylgruppe, eine Vinylgruppe, eine Alkylgruppe, die einen Substituenten aufweist, oder eine Arylgruppe, die einen Substituenten aufweist, darstellt, wenn R¹ eine Alkylgruppe, die einen Substituenten aufweist, oder eine Arylgruppe, die einen Substituenten aufweist, darstellt, jeder Substituent eine ethylenische Doppelbindung enthält; R² und R³ jeweils eine Vinylgruppe, eine Alkylgruppe, die einen Substituenten aufweist, eine Arylgruppe, die einen Substituenten aufweist, eine Alkoxygruppe, die einen Substituenten aufweist, oder eine Aryloxygruppe, die einen Substituenten aufweist, darstellen; R¹, R² und R³ miteinander verbunden sein können, um einen Ring zu bilden.

2. Laminat mit Barrierewirkung gemäß Anspruch 1, worin der Substituent, der eine ethylenische Doppelbindung enthält, eine Acryloylgruppe, eine Methacryloylgruppe oder eine Vinylgruppe umfasst.

3. Laminat mit Barrierewirkung gemäß Anspruch 1 oder 2, worin R² und R³ jeweils eine Alkylgruppe, eine Arylgruppe oder eine Alkoxygruppe sind.

4. Laminat mit Barrierewirkung gemäß irgendeinem der Ansprüche 1 bis 3, worin die durch die Formel (1) dargestellte Verbindung eine Acrylatverbindung oder eine Methacrylatverbindung ist.

5. Laminat mit Barrierewirkung gemäß irgendeinem der Ansprüche 1 bis 4, worin die durch die Formel (1) dargestellte Verbindung mindestens zwei polymerisierbare Gruppen aufweist.

6. Laminat mit Barrierewirkung gemäß irgendeinem der Ansprüche 1 bis 5, worin die polymerisierbare Zusammensetzung 1 bis 50 Gew.% der durch die Formel (1) dargestellten Verbindung umfasst.

7. Laminat mit Barrierewirkung gemäß irgendeinem der Ansprüche 1 bis 6, worin die anorganische Schicht auf der organischen Schicht ist.

8. Laminat mit Barrierewirkung gemäß irgendeinem der Ansprüche 1 bis 7, worin die organische Schicht durch ein Flash-Gasabscheidungsverfahren gebildet ist.

9. Laminat mit Barrierewirkung gemäß irgendeinem der Ansprüche 1 bis 8, worin die anorganische Schicht mindestens eine Spezies umfasst, ausgewählt aus einem Metalloxid, einem Metallnitrid, einem Metallcarbid, einem Metalloxid-Nitrid und einem Metalloxid-Carbid.

10. Laminat mit Barrierewirkung gemäß irgendeinem der Ansprüche 1 bis 9, worin die anorganische Schicht durch ein Sputter-Verfahren gebildet ist.

11. Laminat mit Barrierewirkung gemäß irgendeinem der Ansprüche 1 bis 10, worin mindestens zwei organische Schichten und mindestens zwei anorganische Schichten alternierend laminiert sind.

12. Gassperrfolie, umfassend ein Substrat und das Laminat mit Barrierewirkung gemäß irgendeinem der Ansprüche 1 bis 11 auf dem Substrat.

13. Vorrichtung, umfassend das Laminat mit Barrierewirkung gemäß irgendeinem der Ansprüche 1 bis 11.

14. Vorrichtung gemäß Anspruch 13, welches die Gassperrfolie gemäß Anspruch 12 als ein Substrat aufweist.

15. Vorrichtung gemäß Anspruch 13 oder 14, versiegelt mit dem Laminat mit Barrierewirkung oder der Gassperrfolie gemäß Anspruch 11.

16. Vorrichtung gemäß irgendeinem der Ansprüche 13 bis 15, welche eine elektronische Vorrichtung oder eine organische EL-Vorrichtung ist.

## Revendications

1. Stratifié formant barrière comprenant au moins une couche organique et au moins une couche inorganique, où la couche organique est formée par durcissement d'une composition polymérisable comprenant un composé représenté par la formule (1) suivante : 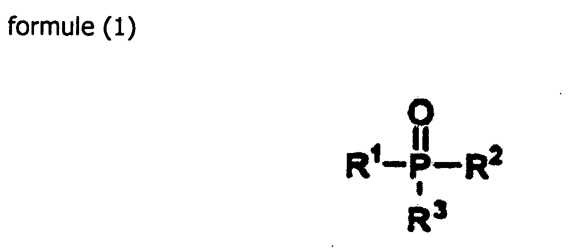 où R¹ représente un groupe acryloyle, un groupe méthacryloyle, un groupe vinyle, un groupe alkyle ayant un substituant ou un groupe aryle ayant un substituant, quand R¹ est un groupe alkyle ayant un substituant ou un groupe aryle ayant un substituant, chaque substituant contient une double liaison éthylénique ; R² et R³ représentent chacun un groupe vinyle, un groupe alkyle ayant un substituant, un groupe aryle ayant un substituant, un groupe alcoxy ayant un substituant ou un groupe aryloxy ayant un substituant ; R¹, R² et R³ peuvent être liés entre eux pour former un cycle.

2. Stratifié formant barrière selon la revendication 1, où le substituant contenant une double liaison éthylénique contient un groupe acryloyle, un groupe méthacryloyle ou un groupe vinyle.

3. Stratifié formant barrière selon la revendication 1 ou 2, où R² et R³ sont chacun un groupe alkyle, un groupe aryle ou un groupe alcoxy.

4. Stratifié formant barrière selon l'une quelconque des revendications 1 à 3, où le composé représenté par la formule (1) est un composé acrylate ou un composé méthacrylate.

5. Stratifié formant barrière selon l'une quelconque des revendications 1 à 4, où le composé représenté par la formule (1) a au moins deux groupes polymérisables.

6. Stratifié formant barrière selon l'une quelconque des revendications 1 à 5, où la composition polymérisable comprend 1 à 50 % en poids du composé représenté par la formule (1).

7. Stratifié formant barrière selon l'une quelconque des revendications 1 à 6, où la couche inorganique est sur la couche organique.

8. Stratifié formant barrière selon l'une quelconque des revendications 1 à 7, où la couche organique est formée par un procédé de dépôt éclair en phase vapeur.

9. Stratifié formant barrière selon l'une quelconque des revendications 1 à 8, où la couche inorganique comprend au moins une espèce choisie parmi un oxyde métallique, un nitrure métallique, un carbure métallique, un oxynitrure métallique et un oxycarbure métallique.

10. Stratifié formant barrière selon l'une quelconque des revendications 1 à 9, où la couche inorganique est formée par un procédé de pulvérisation cathodique.

11. Stratifié formant barrière selon l'une quelconque des revendications 1 à 10, où au moins deux de couches organiques et au moins deux de couches inorganiques sont stratifiées tour à tour.

12. Film formant barrière aux gaz comprenant un substrat et le stratifié formant barrière selon l'une quelconque des revendications 1 à 11 sur le substrat.

13. Dispositif comprenant le stratifié formant barrière selon l'une quelconque des revendications 1 à 11.

14. Dispositif selon la revendication 13, qui a le film formant barrière aux gaz selon la revendication 12 comme substrat.

15. Dispositif selon la revendication 13 ou 14, scellé avec le stratifié formant barrière ou le film formant barrière aux gaz selon la revendication 11.

16. Dispositif selon l'une quelconque des revendications 13 à 15, qui est un dispositif électronique ou un dispositif EL organique.
